## Europäisches Patentamt

## European Patent Office

## Office européen des brevets

(11) Publication number: **0 136 332**
**B1**

(12) # EUROPEAN PATENT SPECIFICATION

(45) Date of publication of patent specification: **03.06.87**

(51) Int. Cl.⁴: **B 41 J 3/12, H 01 F 15/10, H 05 K 3/34**

(21) Application number: **84901047.5**

(22) Date of filing: **15.02.84**

(86) International application number:
**PCT/US84/00209**

(87) International publication number:
**WO 84/03253 30.08.84 Gazette 84/21**

(54) **WIRE COIL ASSEMBLY FOR MATRIX PRINT HEAD AND MANUFACTURING METHOD.**

(30) Priority: **25.02.83 US 470011**

(43) Date of publication of application:
**10.04.85 Bulletin 85/15**

(45) Publication of the grant of the patent:
**03.06.87 Bulletin 87/23**

(84) Designated Contracting States:
**DE FR GB**

(56) References cited:
**EP-A-0 058 901**
**FR-A-1 166 171**
**FR-A-2 168 219**
**GB-A- 873 467**
**GB-A-1 208 889**
**US-A-2 912 481**
**US-A-3 486 224**
**US-A-4 229 722**
**US-A-4 244 658**

(73) Proprietor: **NCR Corporation**
**World Headquarters**
**Dayton, Ohio 45479 (US)**

(72) Inventor: **WIRTH, Robert, L.**
**115 Simsbury Drive**
**Ithaca, NY 14850 (US)**
Inventor: **WEEKS, David, E.**
**2083 West Danby Road**
**Newfield, NY 14867 (US)**
Inventor: **REECE, John, W.**
**106 Cambridge Place**
**Ithaca, NY 14850 (US)**

(74) Representative: **Robinson, Robert George**
**International Patent Department NCR Limited**
**206 Marylebone Road**
**London NW1 6LY (GB)**

Courier Press, Leamington Spa, England.

# Description

## Technical Field

The present invention relates to an assembly including a coil wire-carrying member and a printed circuit board, and to a method of securing a wire coil carrying member to a printed circuit board.

Such method and assembly are particularly useful in the manufacture of wire matrix print heads, more particularly print heads in which a plurality of wires are caused to be propelled against a record medium by respective clapper-type, solenoid actuated, print wire drivers for printing dot matrix characters in accordance with external control signals.

## Background Art

In wire matrix print heads of this kind, the solenoids are arranged or grouped in a manner to drive the respective print wires a precise distance from a rest or non-printing position to an impact or printing position. The print wires are generally engaged by the clapper members or armatures which are caused to be moved such precise distance when the solenoid coil is energized and wherein the armature normally operates against the action of a return spring.

It has been quite common to provide an arrangement or grouping of such solenoids in a circular configuration to take advantage of reduced space available in the manner of locating the print wires in that area from the solenoid to the front tip of the print head adjacent the record media. In this respect, the actuating ends of the print wires are spaced in accordance with the circular arrangement and the operating or working ends of the print wires are closely spaced in vertically-aligned manner adjacent the record media. The availability of narrow or compact actuators permits a narrower print head to be used and thereby reduces the width of the printer because of the reduced clearance at the ends of the print line. The print head can also be made shorter because the narrow actuators can be placed in side-by-side manner closer to the record media for a given amount of wire curvature. The print head, with the wire elements aligned in a vertical line, is supported on a print head carriage which is caused to be moved or driven in a horizontal direction for printing a line manner.

The method according to the invention may be advantageously used in the manufacture of wire matrix print heads of the above type, wherein a printed circuit board serves as a support for, and provides electrical connections to, the solenoid coils for actuating the print wire drivers.

A method of securing a coil-carrying bobbin to a printed circuit board, is described in FR—A—2168219. According to this patent, the bobbin is provided with a plurality of metal posts each having grooves formed therein, into which the ends of the coil wires are placed. The posts are then passed through respective apertures in the printed circuit board and the wire ends are soldered to respective conductors of the printed circuit board.

A plug-in assembly is disclosed in GB—A—873467 which comprises a coil carried by a heat resistant base plate provided with V or U-shaped metal tags. The coil wire ends are soldered to their respective tags and the excess wire is trimmed off. The assembly is then "plugged-in" to approximate apertures in a printed circuit board. In one arrangement, the wire ends may be soldered to the tags after the assembly is "plugged-in".

## Disclosure of the Invention

It is an object of the present invention to provide a simple, compact and low cost assembly and a simplified method of assembly of a wire coil-carrying member and a printed circuit board.

Thus, according to the invention, there is provided an assembly including a wire coil-carrying member and a printed circuit board having conductors thereon, in which said wire coil-carrying member has first and second projecting posts having grooves therein for accommodating the ends of the coil wire and extending through corresponding apertures in the printed circuit board, and in which the ends of the coil wire are soldered to conductors of said printed circuit board, characterized in that each post is formed integrally with said coil-carrying member and has a length such that the tip of the post, when inserted into the corresponding aperture, is essentially in alignment with the underside of said printed circuit board, in that each post has at its circumferential surface first and second grooves extending axially along it, and in that each end of the coil wire extends along and within said first groove, across the tip, and along and within said second groove of the respective post and is soldered to a respective conductor at the tip of the post.

According to another aspect of the invention, there is provided a method of securing a wire coil-carrying member to a printed circuit board having conductors thereon, including the steps of providing said wire coil-carrying member with first and second projecting posts, providing the posts at their respective circumferential surfaces with grooves for accommodating the end of the coil wire, passing said posts carrying the wire ends through corresponding apertures in the printed circuit board, and soldering the wire ends to respective conductors of said printed circuit board, characterized by the steps of forming said posts integrally with said coil-carrying member in such a way that the tip of each post, when inserted into the corresponding aperture, becomes essentially aligned with the underside of said printed circuit board; providing each post with first and second axially extending grooves; placing one end of the coil wire into and along said first groove, across the tip and into and along said second groove of said first post; placing the other end of the coil wire into and along said first groove, across the tip and into and along said second groove of said second post; passing said posts through the corresponding apertures in said printed circuit board; and soldering the wire ends to said conductors at the tip of each post.

It will be appreciated that the assembly according to the invention has the advantage that it can be made by a simple and low cost process by reason of integrally moulding the grooved posts with the bobbin flange. A further advantage is that the coil wire ends are well protected owing to the groove configuration and wire routing and by reason of the fact that the wire ends are completely covered at the tip of each post by the solder providing connection with the printed circuit board conductors.

Brief Description of the Drawings

Embodiments of the invention will now be described, by way of example, with reference to the accompanying drawings, in which:—

Fig. 1 is a perspective view showing certain parts of a print head in exploded manner;

Fig. 2 is a top plan view showing one embodiment of a coil bobbin;

Fig. 3 is a sectional view taken along the line 3—3 of Fig. 2;

Fig. 4 is a sectional view showing the bobbin wound coil and circuit board assembly;

Fig. 5 is an enlarged view of the coil wiring connection with the circuit board;

Fig. 6 is a top plan view showing another embodiment of the coil bobbin; and

Fig. 7 is a sectional view taken along the line 7—7 of Fig. 6.

Best Mode for Carrying Out the Invention

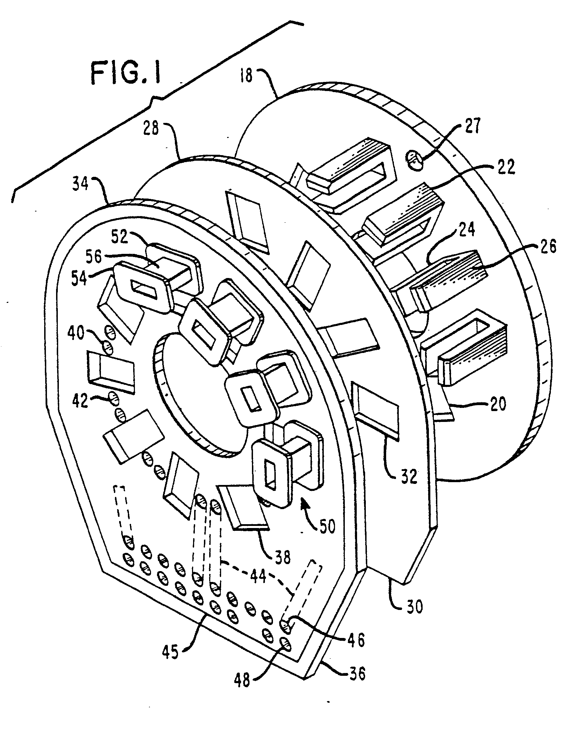

Fig. 1 is an illustration, in exploded manner, of several of the parts included in the present invention and wherein a backplate 18, of circular shape and having spaced apertures or windows 20 therein, carries a plurality of U-shaped magnetic core members 22 each of which comprises inner and outer poles 24 and 26. A hole 27 is provided in the backplate 18 for a ground connection. An insulating spacer 28 of paper or like material is provided next to the backplate 18 and has a lower portion 30 and a plurality of apertures or windows 32 for receiving the pole portions 24 and 26 of the core members 22. Next is a printed circuit board 34 likewise of similar shape as the spacer 28 and having a lower portion 36 and including a plurality of apertures or windows 38 therein corresponding generally in location and size with the windows 32 in the spacer 28. Each of the three elements, i.e., the backplate 18, the spacer 28 and the circuit board 34 includes a central aperture therein for receiving a member for fastening the three elements in a wire matrix print head, the details of which are disclosed in an international application in the name of the present applicant filed on the same day as the present application and entitled "Wire Matrix Print Head".

A pair of copper-lined holes 40 and 42 are positioned adjacent each window 38 in the printed circuit board 34 and copper runs or conductors 44 extend on one side (the back side in Fig. 1) of the board from certain ones of such holes 40 and 42 to copper-lined holes 46 formed in a row along the lower portion 36. A second row of copper-lined holes 48 is positioned just below the holes 46 for connecting with other ones of the holes 40 and 42 on the other side (the front side in Fig. 1) of the circuit board, which front side includes a copper coating or plating thereon, schematically indicated 45, for connecting the common or neutral portion of each circuit. The construction of the copper runs or conductors on a printed circuit board 34 is well-known, as are the connectors typically used to connect with the conductors on the circuit board.

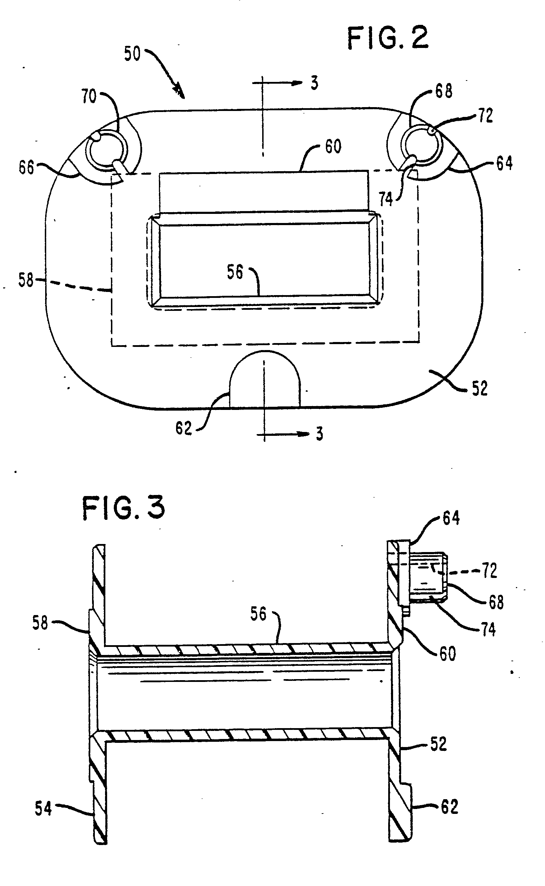

Fig. 2 shows a top view of a coil bobbin 50 which is secured to the circuit board 34. The bobbin 50 is made of a plastic material such as nylon or the like and includes flange ends 52 and 54 (Fig. 3) which may be considered to be somewhat rectangular-shaped and connected by a hollow rectangular-shaped central body portion 56. The flange 54 has a slightly raised portion 58 on the surface thereof and the flange 52 has a smaller and slightly raised portion 60, as best seen in Fig. 3. There are three pads 62, 64 and 66 (Fig. 2) on the outer surface of the flange 52 for providing a seating plane with the surface of the circuit board 34 when in place and supported thereby. Additionally, the three pads 62, 64 and 66 provide space between the surfaces of the circuit board 34 and bobbin 50 to enable flushing of any liquids or materials used in assembling the parts. A pair of posts 68 and 70, integral with the flange 52, are positioned at two corners of the flange 52 and extend outwardly from the pads 64 and 66. Each of the posts 68 and 70 has opposed grooves 72 and 74, with the outside groove 72 extending through the flange 52.

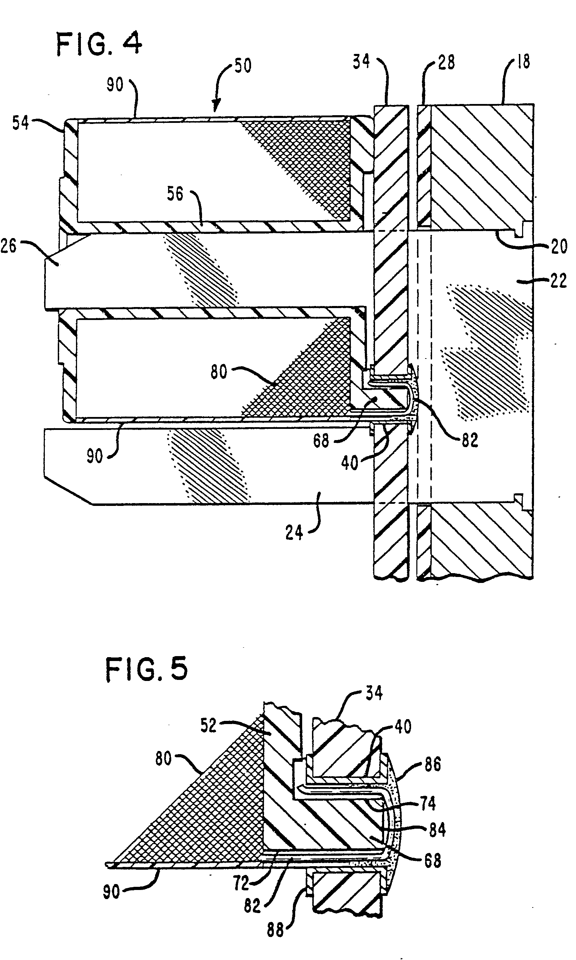

Fig. 4 is a section of the assembly of a bobbin 50 and a circuit board 34 taken through the post 68 and the pad 62. The assembly includes in excess of 200 turns of copper magnet wire 80 wound on the bobbin in coil form. The coil wire 80 is wrapped with several layers of tape 90 in well-known manner. The ends of the wire 80 are placed in the grooves 72 and 74 of the posts 68 and 70 and then the wound bobbin 50 is attached to the circuit board 34 with the posts 68 and 70 extending through the respective holes 40, 42 in the circuit board. As best understood from Fig. 5, each end 82 of the coil wire 80 is disposed in and along the one groove 72, across a tip 84 of the respective posts 68 and 70, and then in and along the other groove 74. After the wire ends 82 are seated in the grooves 72, 74 of the respective posts and the pads 62, 64, 66 of the bobbin 50 are placed firmly against the surface of the circuit board 34 with the posts 68 and 70 extending through the respective holes 40, 42, a portion of solder 86 is placed, as in a wave soldering or like operation, across the wire ends 82 on the tip 84 of the posts 68, 70 and over the copper lining, designated as 88, in and adjacent each hole 40, 42 in the circuit board 34. The backplate 18 carries the core members 22 secured thereto as by pressing same through the windows 20. The insulating spacer 28 is placed adjacent the backplate 18 with the core member poles 24 and 26 extending through the windows 32 of the spacer 28, through the windows 38 of the circuit board 34, and with outer pole 26 of core member 22 extending through the hollow body portion 56 of the bobbin 50 (Fig. 4).

It should be noted that the backplate 18 is made of aluminum, the core members 22 are made of silicon iron and the circuit board 34 is epoxy glass.

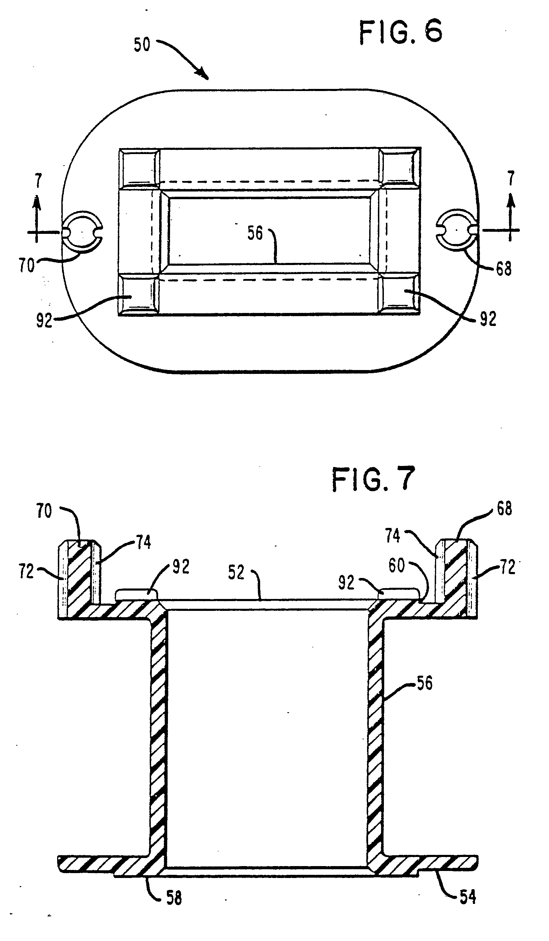

Figs. 6 and 7 illustrate a different arrangement for certain structure of the coil bobbin 50. The flange ends 52 and 54 are the same shape and size as the ends shown in Figs. 2 and 3, however the central body portion 56 is enlarged slightly to better accommodate the outer pole 26 in the assembly of parts. The flange 54 includes the slightly raised portion 58 on the surface thereof and the flange 52 also has the raised portion 60. There are four square pads 92 arranged in symmetrical manner on the flange 52 for providing a seating plane with the surface of the circuit board 34 and holding the flange 52 in a stable condition when mounting the bobbin 50 on the circuit board 34. Further, the pads 92 provide space between the surfaces of the circuit board 34 and bobbin 50 to enable flushing of any liquids or materials used in the soldering operation. The posts 68 and 70, integral with the flange 52, are positioned along a centerline thereof. Each of the posts 68 and 70 has the opposed grooves 72 and 74 with the outside groove extending through the flange 52.

It is thus seen that herein shown and described is a wire matrix print head solenoid assembly having a plurality of print wire actuating coils directly connected with and supported from a printed circuit board.

**Claims**

1. An assembly including a wire coil-carrying member (50) and a printed circuit board (34) having conductors (44) thereon, in which said wire coil-carrying member (50) has first and second projecting posts (68, 70) having grooves (72, 74) therein for accommodating the ends (82) of the coil wire (80) and extending through corresponding apertures (40, 42) in the printed circuit board (34), and in which the ends (82) of the coil wire (80) are soldered to conductors of said printed circuit board (34), characterized in that each post (68, 70) is formed integrally with said coil-carrying member (50) and has a length such that the top of the post, when inserted into the corresponding aperture, is essentially in alignment with the underside of said printed circuit board (34), in that each post (68, 70) has at its circumferential surface first and second grooves (72, 74) extending axially along it, and in that each end (82) of the coil wire (80) extends along and within said first groove (72), across the tip (84), and along and within said second groove (74) of the respective post (68, 70) and is soldered to a respective conductor at the tip (84) of the post (68, 70).

2. An assembly according to claim 1, characterized in that said wire coil-carrying member is a bobbin (50) including a plurality of raised portions (62, 64, 66, 92) on one flange end (52) thereof for providing a seating plane with one surface of said printed circuit board (34).

3. An assembly according to claim 2, characterized in that one of the grooves (72) in each of said first and second posts (68, 70) is arranged to continue as an aperture through the said flange end (52) of said bobbin (50).

4. An assembly according to claim 2, characterized in that said bobbin (50) is generally rectangular in shape and said first and second posts (68, 70) are located on respective corners of said one flange end (52) of said bobbin (50).

5. An assembly according to claim 2, characterized in that said bobbin (50) is generally rectangular in shape and said first and second posts (68, 70) are located on respective sides of said one flange end (52) of said bobbin (50).

6. An assembly according to claim 1, characterized in that one major surface of said printed circuit board (34) has a copper coating (45) thereon, said conductors (44) being runs of copper extending on the other major surface of said printed circuit board (34) terminating at individual copper lined apertures (40, 42).

7. A wire matrix print head including a plurality of assemblies claimed in any one of claims 1 to 7, characterized in that said printed circuit board (34) serves at a support for, and provides electrical connections to, the coils (80) of a plurality of electromagnetic actuating means (22, 24, 50) for the print wires.

8. A method of securing a wire coil-carrying member (50) to a printed circuit board (34) having conductors (44) thereon, including the steps of providing said wire coil-carrying member (50) with first and second projecting posts (68, 70), providing the posts (68, 70) at their respective circumferential surfaces with grooves (72, 74) for accommodating the end (82) of the coil wire (80), passing said posts (68, 70) carrying the wire ends (82) through corresponding apertures (40, 42) in the printed circuit board (34), and soldering the wire ends (82) to respective conductors of said printed circuit board (34), characterized by the steps of forming said posts (68, 70) integrally with said coil-carrying member (50) in such a way that the tip of each post, when inserted into the corresponding aperture, becomes essentially aligned with the underside of said printed circuit board (34); providing each post (68, 70) with first and second axially extending grooves (72, 74); placing one end (82) of the coil wire (80) into and along said first groove (72), across the tip (84) and into and along said second groove (74) of said first post (68); placing the other end (82) of the coil wire (80) into and along said first groove (72), across the tip (84) and into and along said second groove (74) of said second post (70); passing said posts (68, 70) through the corresponding apertures (40, 42) in said printed circuit board (34); and soldering the wire ends (82) to said conductors at the tip (84) of each post (68, 70).

## Patentansprüche

1. Anordnung mit einem eine Drahtwicklung tragenden Glied (50) und einer gedruckten Schaltungsplatte (34) mit Leitern (44) darauf, bei der das die Drahtwicklung tragende Glied (50) einen ersten und zweiten vorragenden Bolzen (68, 70) aufweist, die Nuten (72, 74) aufweisen, um die Enden (82) des Wicklungsdrahtes (80) unterzubringen, und die sich durch entsprechende Öffnungen (40, 42) in der gedruckten Schaltungsplatte (34) erstrecken und bei der die Enden (82) des Wicklungsdrahtes (80) mit den Leitern der gedruckten Schaltungsplatte (34) verlötet sind, dadurch gekennzeichnet, dass jeder Bolzen mit dem die Drahtwicklung tragenden Glied (50) integral gebildet ist und so lang ist, dass die Spitze (84) des Bolzens, wenn er in die Entsprechende Öffnung eingesetzt wird, mit der Unterseite der gedruckten Schaltungsplatte (34) wesentlich glatt ist, dass jeder Bolzen (68, 70) auf seiner Peripherie eine erste und zweite Nut (72, 74) aufweist, die sich längs der Drehlinie erstreckt, und dass jedes Ende (82) des Wicklungsdrahtes (80) sich längs und innerhalb der ersten Nut (72) über die Spitze (84) und längs und innerhalb der zweiten Nut (74) des entsprechenden Bolzens (68, 70) erstreckt, und an der Spitze (84) des Bolzens (68, 70) mit dem entsprechenden Leiter verlötet ist.

2. Anordnung nach Anspruch 1, dadurch gekennzeichnet, daß das die Drahtwicklung tragende Glied ein Spulenkörper (50) mit einer Vielzahl von Erhebungen (62, 64, 66) an einem Flanschende (52) desselben ist, zum Bilden einer Sitzebene mit einer Fläche der gedruckten Schaltungskart (34).

3. Anordnung nach Anspruch 2, dadurch gekennzeichnet, daß eine der Nuten (74) in jedem ersten und zweiten Bolzen (68, 70) angeordnet ist, um als eine Öffnung durch das Flanschende (52) des Spulenkörpers (50) sich furtzusetzen.

4. Anordnung nach Anspruch 2, dadurch gekennzeichnet, daß das Spulenkörper (50) durchgehend rechteckig in der Form ist und die erste und zweite Bolzen (68, 70) an entsprechenden Ecken des einen Flanschendes (52) des Spulenkörpers (50) angeordnet sind.

5. Anordnung nach Anspruch 2, dadurch gekennzeichnet, daß der Spulenkörper (50) durchgehend rechteckig in der Form ist und der erste und zweite Bolzen (68, 70) an entsprechenden Seiten des einen Flanschendes (52) des Spulenkörpers (50) angeordnet sind.

6. Anordnung nach Anspruch 1, dadurch gekennzeichnet, daß eine größere Fläche der gedruckten Schaltungskarte (34) eine Kupferbeschichtung (45) darauf hat, wobei die Leiter (44) Bahnen von Kupfer sind, die sich auf der größeren Fläche der gedruckten Schaltungskart (34) erstrecken und an einzelnen, mit Kupfer versehenen Öffnungen (40, 42) enden.

7. Drahtmatrixdruckkopf mit einer Vielzahl von Anordnungen, wie sie in einem der Ansprüche 1 bis 7 beansprucht sind, dadurch gekennzeichnet, daß die gedruckte Schaltungskarte (34) als eine Abstützung für die Wicklungen (80) einer Vielzahl von elektromagnetischen Betätigungsvorrichtungen (22, 24, 50) für die Druckdrähte dient und elektrisches Verbindungen dazu herstellt.

8. Verfahren zum Befestigen eines eine Drahtwicklung tragenden Gliedes (50) an einer gedruckten Schaltungskart (34) mit Leitern (44) darauf mit den Schritten Versehen des die Drahtwicklung tragenden Gliedes mit einem ersten und zweiten vorragenden Bolzen (68, 70), Versehen der Bolzen (68, 70) an seinen entsprechenden peripherischen Oberflächen mit Nuten (72, 74) um die Enden (82) des Wicklungsdrahtes unterzubringen, Hindurchführen der die Drahtenden tragenden Bolzen (68, 70) durch entsprechende Öffnungen (40, 42) in der gedruckten Schaltungskarte (34) und Verlöten der Drahtenden (82) mit den entsprechenden Leitern der gedruckten Schaltungskarte (34), gekennzeichnet durch die Schritte Bildung der Bolzen (68, 70) integral mit dem die Drahtwicklung tragenden Glied (50) so dass die Spitze jedes Bolzens, wenn er in die entsprechende Öffnung engesetzt wird, mit der Unterseite der gedruckten Schaltungsplatte (34) wesentlich glatt liegt, Versehen jedes Bolzens (68, 70) mit einer ersten und zweiten Nut (72, 74) die sich längs der Drehlinie ertstreckt, Einbringen eines Endes (82) des Wicklungsdrahtes (80) in und längs der ersten Nut (72) über die Spitze (84) und in und längs der zweiten Nut (74) des ersten Bolzens (68), Einbringen des anderen Endes (82) des Wicklungsdrahtes (80) in und längs der ersten Nut (72) über die Spitze (84) und in und längs der zweiten Nut (74) des zweiten Bolzens (70); Durchführen der Bolzen (68, 70) durch die entsprechenden Öffnungen (40, 42) in der Gedruckten Schaltungskarte (34); und Verlöten den Drahtenden (82) mit den Leitern an der Spitze (84) jedes Bolzens (68, 70).

## Revendications

1. Assemblage comprenant un élement (50) de support d'un bobinage de fil et une plaquette (34) à circuit imprimé portant des conducteurs (44), dans lequel ledit élément (50) de support de bobinage de fil comporte un premier et un second plots (68, 70) saillants présentant des gorges (72, 74) pour loger les extrémités (82) du fil (80) et passant par des ouvertures correspondantes (40, 42) dans la plaquette (34) à circuit imprimé, et dans lequel les extrémités (82) du fil (80) de bobinage sont soudées à des conducteurs de ladite plaquette (34) à circuit imprimé, caractérisé en ce que chaque plot (68, 70) est formé d'une seule pièce avec ledit élément (50) de support de bobinage de fil et est d'une longueur telle que l'extrémite (84) du plot, une fois passée dans l'ouverture correspondante s'aligne quasi intégralement avec la surface inférieure de ladite plaquette (34) à circuit imprimé, en ce que chaque plot (68, 70) présente à sa surface périphérique une première et und seconde gorges (72, 74) qui s'étendent le long du plot par rapport à son axe, et en ce que chaque extrémité (82) du fil (80) du bobinage passe le long et à l'intérieur de ladite première gorge (72), transversalement sur l'extrémité (84) et le long et à l'intérieur de ladite seconde gorge (74) du plot correspondant (68, 70), et est soudée au conducteur correspondant à l'extrémite (82) du plot (68, 70).

2. Assemblage selon la revendication 1, caractérisé en ce que ledit élément de support de bobinage de fil est une bobine (50) comprenant plusieurs parties surélevées (62, 64, 66) situées sur un flasque d'extrémité (52) de cette bobine afine d'établir un plan d'appui avec une surface de ladite plaquette (34) à circuit imprimé. ·

3. Assemblage selon la revendication 2, caractérisé en ce que l'une des gorges (74) de chacun desdits premier et second plots (68, 70) est disposée de façon à se prolonger sous la forme d'une ouverture traversant ledit flasque extrême (52) de ladite bobine (50).

4. Assemblage selon la revendication 2, caractérisé en ce que ladite bobine (50) est de forme globalement rectangulaire et lesdits premier et second plots (68, 70) sont situés sur des angles correspondants dudit premier flasque extrême (52) de ladite bobine (50).

5. Assemblage selon la revendication 2, caractérisé en ce que ladite bobine (50) est de forme globalement rectangulaire et lesdits premier et second plots (68, 70) sont situés sur des côtés correspondants dudit premier flasque extrême (52) de ladite bobine (50).

6. Assemblage selon la revendication 1, caractérisé en ce qu'une première surface principale de ladite plaquette (34) à circuit imprimé porte un revêtement (45) de cuivre, lesdits conducteurs (44) étant des rubans de cuivre s'étendant sur l'autre surface principale de ladite plaquette (34) à circuit imprimé et aboutissant à des ouvertures individuelles (40, 42) revêtues de cuivre.

7. Tête d'impression matricielle par fils comprendant plusieurs assemblages selon l'une quelconque des revendications 1 à 7, caractérisé en ce que ladite plaquette (34) à circuit imprimé sert de support pour, et établit des connexions électriques avec, les bobinages (80) de plusieurs moyens d'actionnement électromagnétiques (22, 24, 50) pour les fils d'impression.

8. Procédé de fixation d'un élément (50) de support d'une bobinage de fil sur une plaquette (34) à circuit imprimé portant des conducteurs (44), comprenant les étapes qui consistent à munir ledit élément (50) de support de bobine de fil d'un premier et d'un second plots (68, 70) saillants, à munir lesdits plots (68, 70) à leur surface périphérique respective de gorges (72, 74) destinées à loger les extrémités (82) du fil (80), à faire passer lesdits plots (68, 70) portant les extrémités du fil par les ouvertures correspondantes (40, 42) dans la plaquette (34) à circuit imprimé, et à souder les extrémités (82) du fil aux conducteurs correspondants de ladite plaquette (34) à circuit imprimé, caractérisé par les étapes qui consistent à former lesdits plots (68, 70) d'un seule pièce avec ledit élément (50) de support de bobinage de fil de telle façon que l'extrémité (84) de chaque plot, une fois passée dans l'ouverture correspondante, s'aligne quasi intégralement avec la surface inférieure de ladite plaquette (34) à circuit imprimé, à munir chaque plot (68, 70) d'une première et d'une seconde gorges (72, 74) le long du plot, par rapport à son axe, à placer une première extrémité (82) du fil (80) de bobinage dans et le long de ladite première gorge (72), transversalement sur l'extrémité (84), et dans et le long de ladite seconde gorge dudit premier plot (68), à placer l'autre extrémité (82) du fil (80) de bobinage dans et le long de ladite première gorge (72), transversalement sur l'extrémité (84) et dans et le long de ladite seconde gorge (74) dudit second plot (70), à introduire lesdits plots (68, 70) dans les ouvertures correspondantes (40, 42) de ladite plaquette (34) à circuit imprimé, et à souder les extrémités (82) du fil (80) auxdits conducteurs à l'extrémité (84) de chaque plot (68, 70).

FIG.1

# FIG. 2

# FIG. 3

FIG. 4

FIG. 5

## FIG. 6

## FIG. 7